# EUROPÄISCHE PATENTSCHRIFT

(11) **EP 1 668 167 B1**
(45) Veröffentlichungstag und Bekanntmachung des Hinweises auf die Patenterteilung: **10.12.2008**
(21) Anmeldenummer: 04765686.3
(22) Anmeldetag: 29.09.2004
(51) Int. Cl.: C23C 14/08, C23C 16/40, C23C 4/10, C25D 13/02, C23C 18/12

(54) **SCHUTZ VON METALLISCHEN OBERFLÄCHEN GEGEN THERMISCH BEEINFLUSSTE FALTENBILDUNG (RUMPLING), INSBESONDERE BEI GASTURBINEN**
PROTECTION OF METALLIC SURFACES AGAINST THERMALLY-INDUCED WRINKLING (RUMPLING)
PROTECTION DE SURFACES METALLIQUES CONTRE LA FORMATION DE PLIS THERMIQUEMENT INDUITE (FROISSEMENT)

(30) Priorität: 01.10.2003 DE 10345738
(43) Veröffentlichungstag der Anmeldung: 14.06.2006
(73) Patentinhaber: Deutsches Zentrum für Luft- und Raumfahrt e.V., 51147 Köln (DE)
(72) Erfinder: BARTSCH, Marion, 51103 Köln (DE); BAUFELD, Bernd, 3000 Leuven (BE)
(74) Vertreter: Jönsson, Hans-Peter
(86) Internationale Anmeldenummer: PCT/EP2004/010887
(87) Internationale Veröffentlichungsnummer: WO 2005/033351

(56) Entgegenhaltungen:
- DE-A1- 19 858 701
- US-A- 4 405 660
- US-A1- 2002 132 051
- US-A1- 2003 180 571
- US-B1- 6 312 832

## Beschreibung

Die Erfindung betrifft ein metallisches Bauteil mit einem keramischen Überzug und ein Verfahren zur Herstellung dieses Überzugs sowie die Verwendung dieses Überzugs zum Schutz von metallischen Oberflächen gegen thermisch beeinflusste Faltenbildung (Rumpling).

Metalloberflächen, die hohen thermischen und mechanischen Wechsellasten ausgesetzt sind, können eine Faltenbildung (Rumpling) der Oberfläche zeigen. Das wird beispielsweise an den Oberflächen von Gasturbinenschaufeln, die mit einer metallischen Oxidationsschutzschicht versehen sind, beobachtet. Die Faltenbildung ist eine Aufrauung der Oberfläche und kann zu einer Verminderung der Effektivität und der Lebensdauer der Komponente führen. Speziell im Fall der metallischen Oxidationsschutzschicht auf Gasturbinenschaufeln hat die Aufrauung folgende negative Auswirkungen:
- der aerodynamische Wirkungsgrad wird vermindert,
- von den Rauhigkeitstälern gehen Risse aus, die in das Schaufelmaterial weiterlaufen und zum Versagen führen können,
- durch die Aufrauung wird die Oberfläche der Schutzschicht vergrößert, wodurch die Oxidation des Schutzschichtmaterials beschleunigt und die Schutzfunktion frühzeitig erschöpft wird.

Wesentliche Ursache für die Aufrauung von metallischen Oberflächen unter Betriebsbedingungen sind mechanische Instabilitäten der oberflächennahen Bereiche durch Druckspannungen parallel zur Oberfläche. Die Oberfläche wird bei Überschreiten der Fließspannung plastisch verformt, wobei sich diese plastischen Verformungen bei zyklischer Beanspruchung akkumulieren. Hohe Druckspannungen in oberflächennahen Bereichen werden z.B. durch Temperaturunterschiede zwischen Außen- und Innenwand innengekühlter Komponenten erzeugt.

Bisher wurde versucht, bei metallischen Schutzschichten für Gasturbinenschaufeln durch Modifikationen der chemischen Zusammensetzung eine Verminderung bzw. zeitliche Verzögerung des Rumpling zu erreichen. Die chemische Zusammensetzung der metallischen Oxidationsschutzschicht wird dahingehend verändert, dass bei hohen Temperaturen eine hohe Kriechbeständigkeit erreicht wird und auf der anderen Seite bei niedrigen Temperaturen eine hinreichende Duktilität erhalten bleibt, um die Rissentstehung ausgehend von der Schutzschichtoberfläche zu begrenzen. Patente: [US-Patent 5,958,204; Creech, et al., 28th September 1999, Enhancement of coating uniformity by alumina doping], [US-Patent 6,153,313; Rigney, et al., 28th November 2000, Nickel aluminide coating and coating systems formed therewith], [US-Patent 5,277,936; Olson et al., 11th January 1994, Oxide containing MCrAlY-type overlay coatings].

Ferner ist es bekannt, metallische Werkstücke mit dicken keramischen Schichten zum Zweck der Wärmedämmung in thermisch sehr hoch belasteten Teilen von Triebwerken, Motoren und Gasturbinen zur Stromerzeugung zu versehen. Die Wärmedämmschichten auf Turbinenschaufeln von Triebwerken haben üblicherweise eine Dicke von mindestens 100 µm bis 200 µm. Bei anderen Anwendungsgebieten ist die Dicke noch größer. Sie kann bis zu mehreren Millimetern betragen. Als Nebeneffekt verhindern dicke keramische Wärmedämmschichten die thermisch beeinflusste Faltenbildung. Es gibt Fälle, in denen sich die Aufbringung von Wärmedämmschichten auf metallischen Oberflächen verbietet, beispielsweise weil sie die Wärmeabfuhr von den Oberflächen behindern oder durch zusätzliche Masse und/oder geometrische Veränderungen die Bauteilfunktion beeinträchtigen.

DE 40 28 173 A1 beschreibt ein Schichtensystem zur thermischen Isolierung aus Yttrium-stabilisiertem Zirkoniumoxid mit einer Schichtdicke von etwa 25,4 bis etwa 508 µm.

EP 1 111 085 A1 beschreibt ein Schichtensystem zur thermischen Isolierung mit einer Gesamtschichtdicke von 0,05 bis 5000 µm, wobei mindestens eine der Schichten auch aus stabilisiertem Zirkoniumoxid bestehen kann.

WO 01/23642 A2 beschreibt ein Schichtensystem zur thermischen Isolierung aus verschiedenen Oxiden hauptsächlich von Seltenerden mit einer Schichtdicke von 50 bis 500 µm.

US 4,405,660 beschreibt in Beispiel 1 ein Schichtensystem zur thermischen Isolierung aus Yttrium-stabilisiertem Zirkoniumoxid mit einer Schichtdicke von etwa 127 µm.

Der Erfindung liegt die Aufgabe zugrunde thermisch beeinflusste Faltenbildung (Rumpling) bei metallischen Bauteilen von Rotoren oder Statoren von Strömungsmaschinen zu verhindern.

Zur Lösung der Aufgabe wird gemäß Anspruch 1 ein keramischer Überzug in einer Dicke von weniger als 50 µm verwendet. Bevorzugt ist die Dicke des Überzugs kleiner als 50 µm, insbesondere kleiner als 30 µm besonders bevorzugt kleiner als 20 µm.

Überraschend wurde gefunden, dass in dem ausgewählten Schichtdickenbereich von bis zu 50 µm zwar aufgrund der geringen Schichtdicke keine nennenswerte Wärmedämmwirkung aber dafür unerwartet eine Wirkung gegen thermisch beeinflusste Faltenbildung (Rumpling) beobachtet wurde.

Überraschenderweise hat sich erwiesen, dass bereits dünne keramische Schichten oder weniger Aufrauungen der Oberfläche wirksam und dauerhaft verhindern.

Erfindungsgemäß wird vorgeschlagen, die Aufrauung der Oberflächen durch Aufbringen einer dünnen keramischen Schicht zu verhindern. Keramiken haben bei hohen Temperaturen vielfach eine höhere Steifigkeit und eine deutlich höhere Fließ- bzw. Kriechspannung als Metalle, so dass sie die Aufrauung, d.h. die inelastische Verformung der Metalloberfläche, verhindern können. Die Aufrauung kann bereits durch sehr dünne Schichten von ca. 20 µm Dicke wirksam unterdrückt werden. Selbst unter extremen Bedingungen, wie hohen Druckspannungen im Bereich der Oberfläche, wird mit dünnen Schichten von ca. 20 µm die Aufrauung der Oberfläche verhindert. Die Wirksamkeit der dünnen keramischen Schicht bleibt für die gesamte Lebensdauer der Schicht erhalten.

Vorteilhafterweise weist die zu beschichtende metallische Oberfläche bereits eine oxidische Beschichtung auf. Dadurch kann die Haftung zum metallischen Substrat weiter verbessert werden.

Vorzugsweise beträgt die Dicke des keramischen Überzuges weniger als 30 µm, insbesondere weniger als 25 µm und höchst vorzugsweise weniger als 20 µm. Die geringe Schichtdicke hat den Vorteil, dass die Aufbringung schneller und kostengünstiger erfolgen kann. Ferner können Beschichtungsverfahren eingesetzt werden, die für die Erzeugung dicker Schichten ungeeignet sind. Zudem werden Struktur und Funktion des Bauteils nur in geringem Maße verändert.

Vorzugsweise besteht die zu beschichtende Oberfläche aus einer aluminiumhaltigen metallischen Oxidationsschutzschicht. Die Oxidationsschutzschicht bewirkt das Aufwachsen einer schützenden Aluminiumoxidschicht. Diese verbessert die Haftung des keramischen Überzugs. Ihre Dicke beträgt üblicherweise 0,5 µm und wächst im Betrieb.

Der keramische Überzug besteht vorzugsweise aus einer oxidischen Keramik, beispielsweise auf der Basis von ZrO₂.

Vorzugsweise beträgt die Dicke des keramischen Überzuges mindestens 5 µm, insbesondere mindestens 10 µm. Dadurch kann eine hohe Konformität und Kontinuität der Schicht gewährleistet werden, bei der der gewünschte Effekt gegen thermisch beeinflussten Faltenbildung (Rumpling) noch beobachtet werden kann.

Die Erfindung betrifft ferner ein Verfahren zur Herstellung eines Bauteils gemäß Anspruch 8. Das Verfahren umfasst Elektrophorese mit anschließendem Mikrowellensintern oder Tauchbeschichten mit keramischen Precursoren und anschließendem Sintern.

Die Erfindung eignet sich für metallische Bauteile, die hohen mechanischen Belastungen bzw. Strömungsbelastungen und hohen thermischen Belastungen ausgesetzt sind, insbesondere bei zyklisch auftretenden thermischen Belastungen.

Die Erfindung eignet sich für Rotoren und Statoren von Strömungsmaschinen, insbesondere für Gasturbinenschaufeln von Triebwerken oder von stationären Gasturbinen zur Stromerzeugung.

Im Folgenden wird ein spezielles Ausführungsbeispiel der Erfindung näher erläutert.

Auf eine Probe aus Nickelbasissuperlegieung mit einer Oxidationsschutzschicht aus NiCoCrAlY wurde in Teilbereichen der Oberfläche eine keramische ZrO₂ Schicht mittels EB-PVD aufgebracht. Diese keramische Schicht hatte eine Dicke von ca. 25 µm. Bei einer zyklischen Belastung zwischen 20° und 1.080°C waren an den unbeschichteten Stellen der NiCoCrAlY Schicht nach 10 Zyklen deutliche Aufrauungen festzustellen. Dagegen blieben die Bereiche, die mit einer dünnen ZrO₂ Schicht bedeckt waren, glatt.

Bei der Probe handelte es sich um eine zylindrische Hohlprobe. Während des thermomechanischen Versuchs wurden simultan Temperatur- und mechanische Lastzyklen aufgebracht. Durch Luftkühlung der Probeninnenwand und Aufheizung der Probenaußenwand mit einem Strahlungsofen wurde zusätzlich über der Probenwand ein Temperaturgradient erzeugt, der ähnlich wie in Gasturbinenschaufeln, in der Außenwand Druckspannungen parallel zur Oberfläche erzeugt.

## Patentansprüche

1. Verwendung eines **wenigstens teilweise bedeckenden** keramischen Überzugs einer Dicke von kleiner als 50 µm auf einem metallischen Bauteil **von Rotoren oder Statoren von Strömungsmaschinen** zur Verhinderung der thermisch beeinflussten Faltenbildung (Rumpling).

2. **Verwendung nach Anspruch 1, dadurch gekennzeichnet, dass** die Dicke des Überzugs kleiner als 30 µm und mindestens 5 µm ist.

3. **Verwendung** nach Anspruch 2, **dadurch gekennzeichnet, dass** die beschichtete metallische Oberfläche bereits eine oxidische Beschichtung aufweist.

4. **Verwendung** nach einem der Ansprüche 2 oder 3, **dadurch gekennzeichnet, dass** die beschichtete Oberfläche aus einer aluminiumhaltigen metallischen Oxidationsschutzschicht besteht.

5. **Verwendung** nach einem der Ansprüche 2 bis 4, **dadurch gekennzeichnet, dass** die Dicke des keramischen Überzuges weniger als 20 µm beträgt.

6. **Verwendung** nach einem der Ansprüche 2 bis 5, **dadurch gekennzeichnet, dass** der keramische Überzug aus einer oxidischen Keramik besteht.

7. **Verwendung** nach einem der Ansprüche 2 bis 6, **dadurch gekennzeichnet, dass** die Dicke des keramischen Überzuges mindestens 10 µm beträgt.

8. Verfahren zur Herstellung eines metallischen Bauteils **von Rotoren oder Statoren von Strömungsmaschinen, dadurch gekennzeichnet, dass** man die Oberfläche **durch Elektrophorese und anschließendes Mikrowellensintern oder durch Tauchbeschichten mit keramischen Precursoren und anschließendem Sintern** mit einem dünnen keramischen Überzug einer Dicke von weniger als 30 µm und mindestens 5 µm versieht.

## Claims

1. Use of an at least partially covering ceramic coating having a thickness of smaller than 50 µm on a metallic component of rotors or stators of fluid kinetic machines for preventing thermally influenced rumpling.

2. The use according to claim 1, **characterized in that** the thickness of the coating is smaller than 30 µm and at least 5 µm.

3. The use according to claim 2, **characterized in that** the coated metallic surface already bears an oxidic coating.

4. The use according to either of claims 2 or 3, **characterized in that** the coated surface consists of an aluminum-containing metallic oxidation protection layer.

5. The use according to any of claims 2 to 4, **characterized in that** the thickness of the ceramic coating is less than 20 µm.

6. The use according to any of claims 2 to 5, **characterized in that** the ceramic coating consists of an oxide ceramic material.

7. The use according to any of claims 2 to 6, **characterized in that** the thickness of the ceramic coating is at least 10 µm.

8. A process for preparing a metallic component of rotors or stators of fluid kinetic machines, **characterized in that** the surface is provided with a thin ceramic coating having a thickness of less than 30 µm and at least 5 µm by electrophoresis followed by microwave sintering or by dip coating with ceramic precursors followed by sintering.

## Revendications

1. Utilisation d'un revêtement céramique qui est au moins partiellement recouvrant, avec une épaisseur de moins de 50 µm sur un composant métallique de rotors ou stators de turbomachines pour empêcher la formation d'ondulations influencée thermiquement.

2. Utilisation selon la revendication 1, **caractérisée en ce que** l'épaisseur du revêtement est moins de 30 µm et au moins 5 µm.

3. Utilisation selon la revendication 2, **caractérisée en ce que** la surface métallique revêtée a déjà un revêtement d'oxyde.

4. Utilisation selon l'une quelconque des revendications 2 ou 3, **caractérisée en ce que** la surface revêtée consiste en une couche protectrice contre l'oxydation métallique contenant de l'aluminium.

5. Utilisation selon l'une quelconque des revendications 2 à 4, **caractérisée en ce que** l'épaisseur du revêtement céramique est moins de 20 µm.

6. Utilisation selon l'une quelconque des revendications 2 à 5, **caractérisée en ce que** le revêtement céramique consiste en une céramique oxyde.

7. Utilisation selon l'une quelconque des revendications 2 à 6, **caractérisée en ce que** l'épaisseur du revêtement céramique est au moins 10 µm.

8. Procédé pour la production d'un composant métallique de rotors ou stators de turbomachines, **caractérisée en ce que** l'on procure la surface d'un revêtement céramique mince d'une épaisseur de moins de 30 µm et au moins 5 µm par électrophorèse suivie de frittage par chauffage micro-ondes ou par revêtement par immersion avec des précurseurs céramiques suivi de frittage.
